# EUROPÄISCHE PATENTANMELDUNG

(11) **EP 3 937 224 A1**
(43) Veröffentlichungstag der Anmeldung: **12.01.2022**
(21) Anmeldenummer: 20184725.8
(22) Anmeldetag: 08.07.2020
(51) Int. Cl.: H01L 23/04, H01L 21/50, H05K 3/36, B23K 11/00

(54) **VORRICHTUNG UND VERFAHREN ZUM HERSTELLEN EINES LEISTUNGSHALBLEITERMODULS**

(71) Anmelder: Infineon Technologies AG, 85579 Neubiberg (DE)
(72) Erfinder: MICHALSKI, Sebastian, 59557 Lippstadt (DE); TAKKAC, Alparslan, 59872 Meschede (DE); BOENIG, Guido, 59581 Warstein (DE)
(74) Vertreter: Westphal, Mussgnug & Partner, Patentanwälte mbB

(57) **Zusammenfassung**

Anordnung mit einem Gehäuse (904), wenigstens einer in dem Gehäuse (904) angeordneten Vakuumkammer (906), wobei die Vakuumkammer (906) wenigstens eine erste Öffnung (9041) zum Ansaugen eines Endabschnitts (53) eines Anschlussfußes (52) einer flexiblen leitenden Platte (50) an einem ersten Ende, und eine zweite Öffnung (9042) zum Erzeugen eines Vakuums in der Vakuumkammer (906) an einem zweiten, dem ersten Ende gegenüberliegenden Ende aufweist, und einer Verbindungseinheit (908), die dazu ausgebildet ist in einem Bereich in welchem der Endabschnitt (53) an die erste Öffnung (9041) angesaugt wird eine mechanische Verbindung zwischen dem Endabschnitt (53) und einem Halbleitersubstrat (10) herzustellen während der Endabschnitt (53) an die erste Öffnung (9041) angesaugt wird, wobei das Halbleitersubstrat (10) eine dielektrische Isolationsschicht (11), eine erste elektrisch leitende Schicht (111), eine Vielzahl von auf der ersten elektrisch leitenden Schicht angeordneten Halbleiterbauelementen (20) und eine Vielzahl von auf der ersten elektrisch leitenden Schicht (111) angeordneten Anschlussflächen (60) aufweist.

## Beschreibung

Die vorliegende Erfindung betrifft eine Vorrichtung und ein Verfahren zum Herstellen eines Leistungshalbleitermoduls, insbesondere eines Leistungshalbleitermoduls mit einer flexiblen leitenden Platte oder Folie.

Leistungshalbleitermodule weisen meist eine Bodenplatte in einem Gehäuse auf. Auf der Bodenplatte sind ein oder mehrere Halbleitersubstrate angeordnet. Eine Halbleiteranordnung mit einer Vielzahl steuerbarer Halbleiterbauelemente (z.B. IGBTs) ist auf wenigstens einem der Substrate angeordnet. Ein Halbleitersubstrat weist in der Regel eine elektrisch isolierende Substratschicht (z.B. eine Keramikschicht), eine erste elektrisch leitende Schicht (z.B. eine Metallschicht) die auf einer ersten Seite der Substratschicht angeordnet ist, und, optional, eine zweite elektrisch leitende Schicht (z.B. eine Metallschicht) die auf einer der ersten Seite gegenüberliegenden zweiten Seite der Substratschicht angeordnet ist. Die steuerbaren Halbleiterbauelemente sind beispielsweise auf der ersten elektrisch leitenden Schicht angeordnet. Die zweite elektrisch leitende Schicht ist meistens mit der Bodenplatte verbunden, das heißt, dass diese zwischen der Bodenplatte und der isolierenden Substratschicht angeordnet ist.

Elektrische Verbindungen zwischen den einzelnen Halbleiterbauelementen werden häufig zumindest teilweise auf einer separaten Leiterplatte bereitgestellt, welche beabstandet zu dem wenigstens einen Substrat innerhalb oder außerhalb des Modulgehäuses angeordnet ist. Dadurch müssen auf den Substraten selbst weniger Leiterbahnen oder andere elektrische Verbindungen angeordnet werden, wodurch mehr Platz für die Anordnung von Halbleiterbauelementen verleibt. Eine solche Leiterplatte ist oft mittels elektrischer Verbindungen wie beispielsweise Kontaktstiften elektrisch mit dem wenigstens einen Substrat verbunden.

Hierfür werden auf dem wenigstens einen Substrat entsprechende Verbindungsflächen bereitgestellt. Da es fertigungsbedingt jedoch in der Regel zu gewissen Toleranzen kommt, ist eine genaue Ausrichtung der Leiterplatte oft nicht möglich, wodurch mechanische Spannungen in dem Modul entstehen können. Zudem ist es meist erforderlich entsprechende Verbindungsflächen auf dem wenigstens einen Substrat mit einer entsprechenden Mindestfläche bereitzustellen, um Fertigungstoleranzen ausgleichen zu können. Dies erfordert jedoch Platz auf den Substraten welcher dann nicht mehr zur Anordnung von Halbleiterbauelementen zur Verfügung steht.

Es besteht daher Bedarf an einer Anordnung und einem Verfahren zum Herstellen eines Leistungshalbleitermoduls, mit welchen die beschriebenen Nachteile reduziert werden können.

Eine Anordnung weist ein Gehäuse und wenigstens eine in dem Gehäuse angeordnete Vakuumkammer auf, wobei die Vakuumkammer wenigstens eine erste Öffnung zum Ansaugen eines Endabschnitts eines Anschlussfußes einer flexiblen leitenden Platte an einem ersten Ende, und eine zweite Öffnung zum Erzeugen eines Vakuums in der Vakuumkammer an einem zweiten, dem ersten Ende gegenüberliegenden Ende aufweist. Die Anordnung weist weiterhin eine Verbindungseinheit auf, die dazu ausgebildet ist in einem Bereich in welchem der Endabschnitt an die erste Öffnung angesaugt wird eine mechanische Verbindung zwischen dem Endabschnitt und einem Halbleitersubstrat herzustellen während der Endabschnitt an die erste Öffnung angesaugt wird, wobei das Halbleitersubstrat eine dielektrische Isolationsschicht, eine erste elektrisch leitende Schicht, eine Vielzahl von auf der ersten elektrisch leitenden Schicht angeordneten Halbleiterbauelementen und eine Vielzahl von auf der ersten elektrisch leitenden Schicht angeordneten Anschlussflächen aufweist.

Die Erfindung wird nachfolgend anhand von Beispielen und Bezugnahme auf die Figuren näher erläutert. Dabei bezeichnen gleiche Bezugszeichen gleiche Elemente. Die Darstellung in den Figuren ist nicht maßstäblich.
Figur 1 zeigt einen Querschnitt durch eine Leistungshalbleitermodul-Anordnung mit Kontaktelementen zur Kontaktierung der Halbleitersubstrate;
Figur 2 zeigt einen Querschnitt durch eine Leistungshalbleitermodul-Anordnung mit einer flexiblen leitenden Platte;
Figur 3 zeigt eine Draufsicht auf eine flexible leitende Platte nach dem Stanzen;
Figur 4 zeigt eine dreidimensionale Ansicht einer flexiblen leitenden Platte nach dem Biegen der Anschlussfüße;
Figur 5 zeigt eine dreidimensionale Ansicht eines Halbleitersubstrats mit einer darauf angeordneten flexiblen leitenden Platte gemäß einem Beispiel;
Figur 6 zeigt eine dreidimensionale Ansicht eines Halbleitersubstrats mit einer darauf angeordneten flexiblen leitenden Platte gemäß einem weiteren Beispiel;
Figur 7 zeigt einen vertikalen Querschnitt durch eine Anordnung zum Herstellen eines Leistungshalbleitermoduls gemäß einem Beispiel;
Figur 8 zeigt einen vertikalen Querschnitt durch eine Anordnung zum Herstellen eines Leistungshalbleitermoduls gemäß einem weiteren Beispiel;
Figur 9 , umfassend die Figuren 9A und 9B, zeigt horizontale Querschnitte durch Anordnungen zum Herstellen eines Leistungshalbleitermoduls gemäß weiteren Beispielen;
Figur 10 zeigt einen vertikalen Querschnitt durch eine Anordnung zum Herstellen eines Leistungshalbleitermoduls gemäß einem weiteren Beispiel; und
Figur 11 zeigt eine Draufsicht auf einen Abschnitt eines Anschlussfußes einer flexiblen leitenden Platte gemäß einem Beispiel.

In der nachfolgenden ausführlichen Beschreibung wird anhand konkreter Beispiele veranschaulicht, wie die Erfindung realisiert werden kann. Es versteht sich, dass die Merkmale der verschiedenen hierin beschriebenen Beispiele, sofern nicht anderweitig erwähnt, miteinander kombiniert werden können. Sofern bestimmte Elemente als "erstes Element", "zweites Element",... oder dergleichen bezeichnet werden, dient die Angabe "erstes", "zweites",... lediglich dazu, verschiedene Elemente voneinander zu unterscheiden. Eine Reihenfolge oder Aufzählung ist mit dieser Angabe nicht verbunden. Das bedeutet, dass beispielsweise ein "zweites Element" auch dann vorhanden sein kann, wenn kein "erstes Element" vorhanden ist.

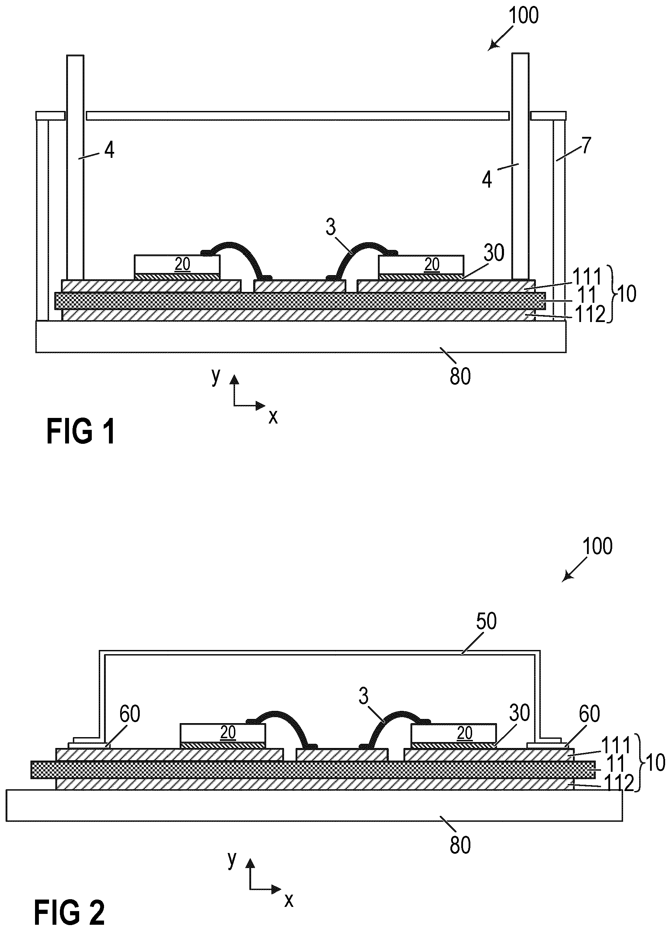

Bezugnehmend auf Figur 1 ist ein Leistungshalbleitermodul 100 mit einem Halbleitersubstrat 10 dargestellt. Das Halbleitersubstrat 10 weist eine dielektrische Isolationsschicht 11, eine (strukturierte) erste elektrisch leitende Schicht 111 und eine (strukturierte) zweite elektrisch leitende Schicht 112 auf. Die erste elektrisch leitende Schicht 111 ist auf einer ersten Seite der dielektrischen Isolationsschicht 11 angeordnet und die zweite elektrische leitende Schicht 112 ist auf einer zweiten, der ersten Seite gegenüberliegenden Seite der dielektrischen Isolationsschicht 11 angeordnet. Die dielektrische Isolationsschicht 11 ist somit zwischen der ersten elektrisch leitenden Schicht 111 und der zweiten elektrisch leitenden Schicht 112 angeordnet. Die zweite elektrisch leitende Schicht 112 ist dabei jedoch optional. Es sind auch Halbleitersubstrate bekannt, welche lediglich die dielektrische Isolationsschicht 11 und die erste elektrisch leitende Schicht 111 aufweisen.

Jede der ersten elektrisch leitenden Schicht 111 und der zweiten elektrisch leitenden Schicht 112 kann aus einem der folgenden Materialien bestehen oder eines der folgenden Materialien aufweisen: Kupfer; eine Kupferlegierung; Aluminium; eine Aluminiumlegierung; jegliches andere Metall oder jegliche andere Metalllegierung welche während des Betriebs des Leistungshalbleitermoduls in einem festen Zustand verbleibt. Das Halbleitersubstrat 10 kann ein keramisches Substrat sein, das heißt, ein Substrat bei welchem die dielektrische Isolationsschicht 11 aus Keramik besteht. Die dielektrische Isolationsschicht 11 kann somit beispielsweise eine dünne Keramikschicht sein. Die Keramik der dielektrischen Isolationsschicht 11 kann beispielsweise aus einem der folgenden Materialien bestehen oder eines der folgenden Materialien aufweisen: Aluminiumoxid; Aluminiumnitrid; Zirkoniumoxid; Siliziumnitrid; Bornitrid; oder jegliche andere Keramik. Beispielsweise kann die dielektrische Isolationsschicht 11 aus einem der folgenden Materialien bestehen oder eines der folgenden Materialien aufweisen: Al₂O₃, AlN, oder Si₃N₄. Das Halbleitersubstrat 10 kann beispielsweise ein so genanntes Direct Copper Bonding (DCB) Substrat, ein Direct Aluminium Bonding (DAB) Substrat, oder ein Active Metal Brazing (AMB) Substrat sein. Das Halbleitersubstrat 10 kann beispielsweise auch eine herkömmliche Leiterplatte (PCB, printed circuit board) sein mit einer nicht-keramischen dielektrischen Isolationsschicht 11. Eine nicht-keramische dielektrische Isolationsschicht 11 kann beispielsweise aus einem gehärteten Harz bestehen oder ein gehärtetes Harz aufweisen.

Wie in Figur 1 dargestellt, können ein oder mehrere Halbleiterkörper 20 auf dem Halbleitersubstrat 10 angeordnet sein. Jeder der Halbleiterkörper 20 auf dem Halbleitersubstrat 10 kann eine Diode, einen IGBT (Bipolartransistor mit isolierter Gate-Elektrode), einen MOSFET (Metall-Oxid-Halbleiter-Feldeffekttransistor), einen JFET (Sperrschicht-Feldeffekttransistor), einen HEMT (Transistor mit hoher Elektronenbeweglichkeit), oder jegliches andere geeignete steuerbare oder nichtsteuerbare Halbleiterbauelement aufweisen. Der eine oder die mehreren Halbleiterkörper 20 können auf dem Halbleitersubstrat 10 eine Halbleiteranordnung bilden. In Figur 1 sind beispielhaft lediglich zwei Halbleiterkörper 20 dargestellt.

Die in Figur 1 dargestellte erste elektrisch leitende Schicht 111 ist eine strukturierte Schicht. "Strukturierte Schicht" bedeutet in diesem Zusammenhang, dass die erste elektrisch leitende Schicht 111 keine durchgehende Schicht ist, sondern Unterbrechungen zwischen verschiedenen Bereichen der Schicht aufweist. Verschiedene Halbleiterkörper 20 können auf demselben Bereich oder auf unterschiedlichen Bereichen der ersten elektrisch leitenden Schicht 111 angeordnet sein. Die verschiedenen Bereiche der ersten elektrisch leitenden Schicht 111 können entweder keine elektrische Verbindung untereinander aufweisen oder können, z.B. mittels Bonddrähten 3, elektrisch miteinander verbunden sein. Jeder der Halbleiterkörper 20 kann mit dem Halbleitersubstrat 10 mittels einer elektrisch leitenden Verbindungsschicht 30 elektrisch und mechanisch verbunden sein. Figur 1 zeigt beispielhaft ein Halbleitersubstrat 10 mit darauf angeordneten Verbindungsschichten 30. Jede der elektrisch leitenden Verbindungsschichten 30 kann grundsätzlich eine Lötschicht, eine Schicht aus einem elektrisch leitenden Klebstoff oder eine Schicht aus einem gesinterten Metallpulver sein, z.B. einem gesinterten Silberpulver.

Das Halbleitersubstrat 10 ist auf einer Bodenplatte 80 angeordnet. Die Bodenplatte 80 kann beispielsweise den Boden eines Gehäuses 7 bilden. Das Gehäuse 7 kann weiterhin Seitenwände und einen Deckel aufweisen. Das Halbleitersubstrat 10 mit der darauf angeordneten Halbleiteranordnung wird durch das Gehäuse 7 vor den verschiedensten Umwelteinflüssen geschützt. Beispielsweise schützt das Gehäuse 7 die Halbleiteranordnung vor mechanischen Beschädigungen. Zudem schützt das Gehäuse 7 insbesondere die metallischen Komponenten der Halbleiteranordnung beispielsweise vor Feuchtigkeit und schädlichen Gasen.

Damit die Halbleiteranordnung von außerhalb des Gehäuses 7 elektrisch kontaktiert werden kann, weist das Leistungshalbleitermodul weiterhin wenigstens ein Kontaktelement 4 auf. Beispielsweise kann eine Versorgungsspannung für die Halbleiteranordnung über die Kontaktelemente 4 bereitgestellt werden. Jedes der Kontaktelemente 4 ragt mit einem ersten Ende in das Gehäuse 7 hinein und ist dort elektrisch mit der Halbleiteranordnung verbunden. In Figur 1 sind beispielhaft zwei Kontaktelemente 4 dargestellt welche elektrisch und mechanisch mit dem Halbleitersubstrat 10 verbunden sind. Jedes der Kontaktelemente 4 kann mit dem Halbleitersubstrat 10 mittels einer elektrisch leitenden Verbindungsschicht elektrisch und mechanisch verbunden sein (Verbindungsschicht in Figur 1 nicht explizit dargestellt). Jede der elektrisch leitenden Verbindungsschichten kann grundsätzlich eine Lötschicht, eine Schicht aus einem elektrisch leitenden Klebstoff oder eine Schicht aus einem gesinterten Metallpulver sein, z.B. einem gesinterten Silberpulver. Elektrische Verbindungen innerhalb des Gehäuses 7 sind in Figur 1 nicht explizit dargestellt. Anstatt mit dem Halbleitersubstrat 10, können die Kontaktelemente 4 jedoch beispielsweise auch mechanisch mit der Bodenplatte 80 verbunden sein. Weiterhin ist es beispielsweise auch möglich, dass die Kontaktelemente 4 in den Seitenwänden des Gehäuses 7 angeordnet sind. Ein zweites Ende der Kontaktelemente 4 ragt nach oben aus dem Gehäuse 7 heraus. Hierfür weist das Gehäuse 7 in der Regel Öffnungen im Deckel auf, durch welche die Kontaktelemente 4 hindurch ragen. In Figur 1 sind geringe Zwischenräume zwischen dem Gehäusedeckel und den Kontaktelementen 4 dargestellt. Derartige Zwischenräume werden jedoch meist durch geeignete Dichtungen oder Dichtungsmaterialien (nicht dargestellt) abgedichtet, um ein Eindringen von Feuchtigkeit und Gasen in das Innere des Gehäuses 7 zu verhindern.

In Figur 1 ragen die Kontaktelemente 4 senkrecht nach oben aus dem Gehäuse 7 heraus. Dies ist jedoch nur ein Beispiel. Beispielsweise können zunächst alle Komponenten (Halbleitersubstrat 10, Halbleiteranordnung, Kontaktelemente 4, etc.) auf der Bodenplatte 80 angeordnet werden. Anschließend kann das Gehäuse 7 auf der Bodenplatte 80 angeordnet werden. Dabei können die Kontaktelemente 4 durch die Öffnungen in dem Gehäuse 7 hindurch geschoben werden. Das obere Ende der Kontaktelemente 4, welches dann aus dem Gehäuse 7 herausragt, kann anschließend beispielsweise um 90° aus seiner ursprünglichen Lage heraus umgebogen werden. Ein Umbiegen der oberen Enden kann beispielsweise eine elektrische Kontaktierung der Kontaktelemente 4 erleichtern. Die Kontaktelemente 4 können beispielsweise mit einer Leiterplatte (nicht explizit dargestellt) elektrisch und mechanisch verbunden werden. Eine solche Leiterplatte kann beispielsweise außerhalb des Gehäuses 7 parallel zu dem Halbleitersubstrat 10 und dem Deckel des Gehäuses 7 angeordnet werden. Die Leiterplatte kann beispielsweise Kontaktlöcher aufweisen durch welche die Kontaktelemente 4 hindurch geschoben werden können. Auf der Leiterplatte können Leiterbahnen angeordnet sein. Dadurch können über die Kontaktelemente 4 und die Leiterplatte elektrische Kontakte zwischen verschiedenen Elementen des Leistungshalbleitermoduls (z.B. zwischen verschiedenen Halbleiterbauelementen 20) hergestellt werden. Auf dem Halbleitersubstrat 10 selber können mehr Halbleiterbauelemente 20 angeordnet werden, da der Platz für die benötigten elektrischen Verbindungen auf der Leiterplatte anstatt auf dem Halbleitersubstrat 10 selber bereitgestellt wird.

Bei dem in Figur 1 dargestellten Leistungshalbleitermodul 100 ist es jedoch erforderlich, dass der Gehäusedeckel und eine zusätzliche Leiterplatte genau in der erforderlichen Position oberhalb des Halbleitersubstrats 10 angeordnet werden, damit die Kontaktelemente 4 beim Zusammenbau des Moduls 100 genau in die entsprechenden Öffnungen und Durchkontaktierungen eingeführt werden können. Eine ungenaue Anordnung aufgrund von Fertigungstoleranzen kann zu ungewollten Spannungen beispielsweise in den Kontaktelementen 4, oder sogar zu Beschädigungen am Modul 10 führen. Der Zusammenbau des Halbleitermoduls 100 aus Figur 1 ist daher sehr aufwendig.

Gemäß dem in Figur 2 dargestellten Beispiel werden elektrische Verbindungen zwischen verschiedenen Elementen (z.B. Halbleiterbauelemente 20) auf einer flexiblen leitenden Platte (z.B. flexible Leiterplatte) 50 bereitgestellt. Flexible leitende Platten 50 sind in der Regel dünner als herkömmliche Leiterplatten. Eine flexible leitende Platte 50 kann eine Dicke von beispielsweise 25µm bis 100µm aufweisen. Beispielsweise können bei der Herstellung von flexiblen leitenden Platten metallische Leiterbahnen auf einer Trägerfolie aufgedruckt oder geätzt werden. Die Trägerfolie kann beispielsweise Polyimid aufweisen. Andere dielektrisch isolierende Materialien sind jedoch ebenfalls möglich. Auf dieser Trägerfolie kann eine metallische Folie aufgebracht werden. Durch Ätzen kann die metallische Folie strukturiert und so die Leiterbahnen geformt werden. Die auf der flexiblen leitenden Platte angeordneten Leiterbahnen können beispielsweise Kupfer oder Aluminium aufweisen. Andere elektrisch leitende Materialien sind jedoch ebenfalls möglich. Durch die geringe Dicke sind die flexiblen leitenden Platten nicht so starr wie herkömmliche Leiterplatten. Ein Verbiegen von flexiblen leitenden Platten ist grundsätzlich möglich, ohne die leitende Platte oder die darauf befindlichen Leiterbahnen zu beschädigen.

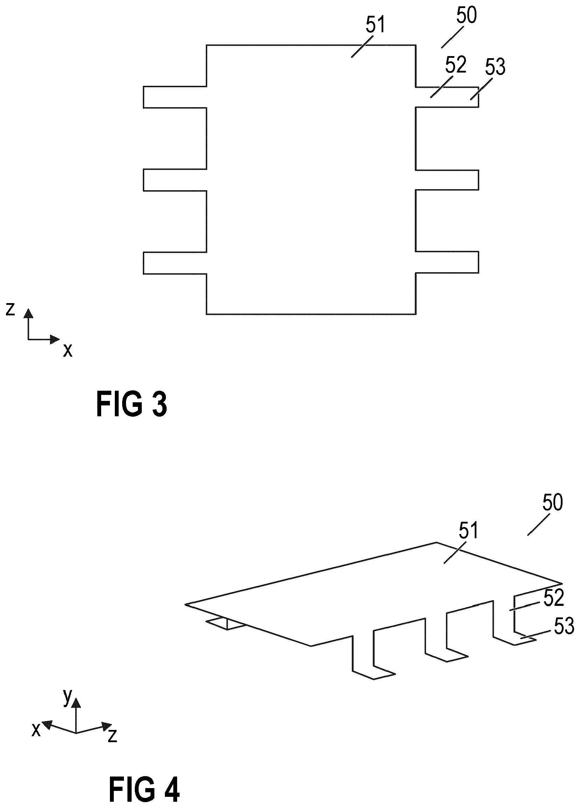

Die in Figur 2 dargestellte flexible leitende Platte 50 weist einen Grundkörper 51 (siehe z.B. Figuren 3 und 4) auf, welcher parallel zu einer ersten Oberfläche des Halbleitersubstrats 10 angeordnet ist. Die erste Oberfläche des Halbleitersubstrats 10 ist dabei diejenige Oberfläche, auf welcher die Halbleiterbauelemente 20 angeordnet sind. Die flexible leitende Platte 50 ist dabei in einer vertikalen Richtung y beabstandet von dem Halbleitersubstrat 10 angeordnet. Die vertikale Richtung y ist eine Richtung senkrecht zu der ersten Oberfläche des Halbleitersubstrats 10. Die flexible leitende Platte 50 weist weiterhin Anschlussfüße 52 (siehe z.B. Figuren 3 und 4) auf, mittels welchen sie mit dem Halbleitersubstrat 10 mechanisch verbunden ist. Die Anschlussfüße 52 erstrecken sich senkrecht zu der ersten Oberfläche von dem Halbleitersubstrat 10 zu dem Grundkörper der flexiblen Leiterplatte 50. Auch auf den Anschlussfüßen 52 können Leiterbahnen angeordnet sein um elektrische Verbindungen zwischen der flexiblen leitenden Platte 50, insbesondere den Leiterbahnen auf dem Grundkörper, und dem Halbleitersubstrat 10 herzustellen.

Die Anschlussfüße 52 können beispielsweise Endabschnitte 53 (siehe z.B. Figuren 3 und 4) aufweisen, welche sich senkrecht von den Anschlussfüßen 52 weg erstrecken. Das heißt, die Endabschnitte 53 können parallel zu der ersten Oberfläche des Halbleitersubstrats 10 verlaufen. Dadurch können die Endabschnitte 53 leichter mit entsprechenden Anschlussflächen 60 auf dem Halbleitersubstrat 10 verbunden werden. Die Anschlussflächen 60 können beispielsweise eine metallische Schicht aufweisen. Eine Verbindung zwischen den Endabschnitten und den entsprechenden Anschlussflächen 60 kann beispielsweise mittels Spaltschweißverfahren, Laserschweißverfahren oder Ultraschallschweißverfahren hergestellt werden.

Die Anschlussflächen 60 weisen in der Regel eine möglichst geringe Fläche auf. Dadurch bleibt auf dem Halbleitersubstrat 60 ausreichend Platz für die erforderlichen Halbleiterbauelemente. Zudem kann das Halbleitersubstrat 10 insgesamt möglichst klein gehalten werden. Dabei ist es jedoch schwierig bei der Herstellung des Halbleitermoduls die Endabschnitte 53 der Anschlussfüße 52 der flexiblen Leiterplatte 50 möglichst genau auf den Anschlussflächen 60 zu platzieren. Durch Fertigungstoleranzen bei der Herstellung der flexiblen leitenden Platte 50 können beispielsweise die Abstände zwischen den Anschlussfüßen 52 geringfügig von den Abständen zwischen den Anschlussflächen 60 abweichen. Die Anschlussfüße 52 werden in der Regel entweder manuell oder überwiegend auch automatisch mittels geeigneter Anordnungen mit den Anschlussflächen 60 verbunden. Auch derartige Anordnungen weisen meist entsprechende Toleranzen auf. Dadurch kann es vorkommen, dass einige oder sogar alle Anschlussfüße 52 nicht direkt auf den Anschlussflächen 60 platziert werden und einen geringfügigen Versatz aufweisen. Dies kann die elektrische Verbindung zwischen der flexiblen leitenden Platte 50 und dem Halbleitersubstrat 10 negativ beeinträchtigen.

Eine flexible leitende Platte 50 kann beispielsweise durch Stanzen oder Zuschneiden (z.B. Laserschneiden) einer entsprechenden Folie hergestellt werden. Eine ausgestanzte oder zugeschnittene flexible leitende Platte 50 in einem Zustand direkt nach dem Stanzen oder Zuschneiden ist beispielhaft in der Draufsicht in Figur 3 dargestellt. Die flexible leitende Platte 50 weist einen Grundkörper 51 und eine Vielzahl von Anschlussfüßen 52 auf. In den Figuren sind beispielhaft sechs Anschlussfüße 52 dargestellt. Dies ist jedoch lediglich ein Beispiel. Eine flexible leitende Platte 50 kann grundsätzlich jegliche Anzahl n von Anschlussfüßen 52 aufweisen, mit n > 1. Der Grundkörper 51 erstreckt sich in einer ersten horizontalen Ebene. Die Anschlussfüße 52 sind mit einem ersten Ende mit dem Grundkörper 51 verbunden und erstrecken sich in der in Figur 3 dargestellten Ausgangslage ebenfalls in der ersten horizontalen Ebene von dem Grundkörper 51 weg. Jeder der Anschlussfüße 52 weist an einem zweiten, dem ersten gegenüberliegenden Ende einen Endabschnitt 53 auf. Auch die Endabschnitte 53 erstrecken sich in der in Figur 3 dargestellten Ausgangslage zunächst in der ersten horizontalen Ebene.

Es folgt anschließend ein Biegevorgang, wie beispielhaft in der dreidimensionalen Ansicht in Figur 4 dargestellt. Die Anschlussfüße 52 werden aus ihrer Ausgangslage heraus um 90° gegenüber dem Grundkörper 51 verbogen, so dass diese sich nach dem Biegen in einer vertikalen Richtung y senkrecht zu der ersten horizontalen Ebene von dem Grundkörper 51 weg erstrecken. Auch die Endabschnitte 53 werden aus ihrer Ausgangslage heraus um 90° gegenüber den Anschlussfüßen 52 verbogen. Somit erstrecken sich die Endabschnitte 53 nach dem Biegen der Anschlussfüße 52 und dem Biegen der Endabschnitte 53 in einer zweiten horizontalen Ebene, welche parallel zu der ersten horizontalen Ebene angeordnet ist.

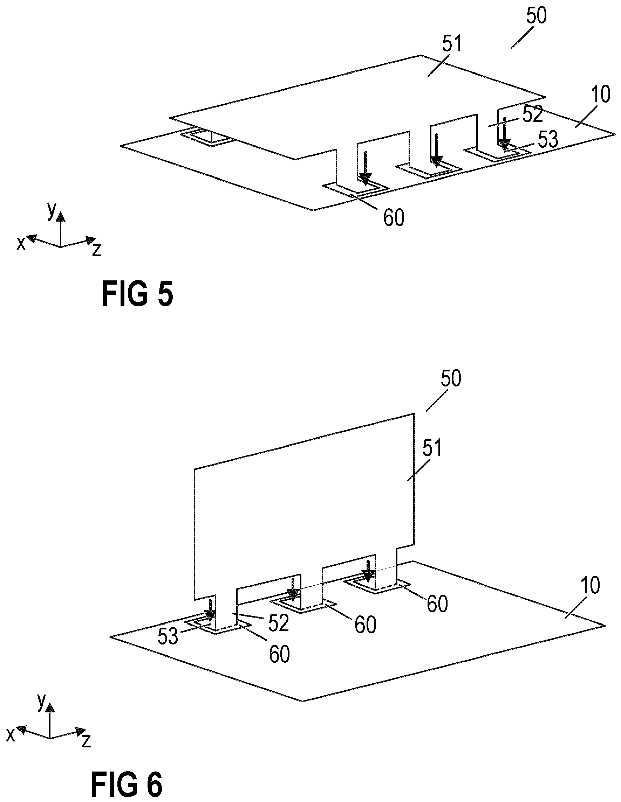

Die derart vorbereitete flexible leitende Platte 50 kann anschließend auf einem Halbleitersubstrat 10 angeordnet und mit diesem verbunden werden. Dies ist beispielhaft in Figur 5 dargestellt. Das Halbleitersubstrat 10 ist in Figur 5 dabei nur schematisch dargestellt. Das heißt, die dielektrische Isolationsschicht 11 und die Metallisierungsschichten 111, 112 sind in Figur 5 nicht explizit dargestellt. Ebenso sind auf dem Halbleitersubstrat 10 angeordnete Halbleiterbauelemente 20, Bonddrähte 3 oder sonstige Elemente nicht explizit dargestellt. Dargestellt sind in Figur 5 lediglich die Anschlussflächen 60, auf welchen die Endabschnitte 53 angeordnet werden. Die Endabschnitte 53 werden zudem elektrisch und mechanisch mit den Anschlussflächen 60 verbunden, was in Figur 5 durch Pfeile angedeutet ist. In den Figuren ist dabei beispielhaft lediglich ein Halbleitersubstrat 10 dargestellt. Es ist jedoch grundsätzlich auch möglich, dass mehr als ein Halbleitersubstrat 10 in ein und demselben Gehäuse 7 und/oder auf der selben Bodenplatte 80 angeordnet sind. Eine einzelne flexible leitende Platte 50 kann dabei auch zwei oder mehr Halbleitersubstrate 10 elektrisch miteinander verbinden.

Die in den Figuren 2 bis 5 dargestellte Anordnung, bei welcher sich der Grundkörper 51 in einer ersten horizontalen Ebene erstreckt, ist jedoch lediglich ein Beispiel. Ebenso ist es möglich, dass sich der Grundkörper 51 in derselben vertikalen Ebene erstreckt wie die Anschlussfüße 52. Die Endabschnitte 53 erstrecken sich bei dieser alternativen Anordnung weiterhin in der zweiten horizontalen Ebene, so dass sich diese parallel zu dem Halbleitersubstrat 10 erstrecken und leicht mit diesem verbunden werden können. Eine solche Anordnung ist beispielhaft in Figur 6 dargestellt.

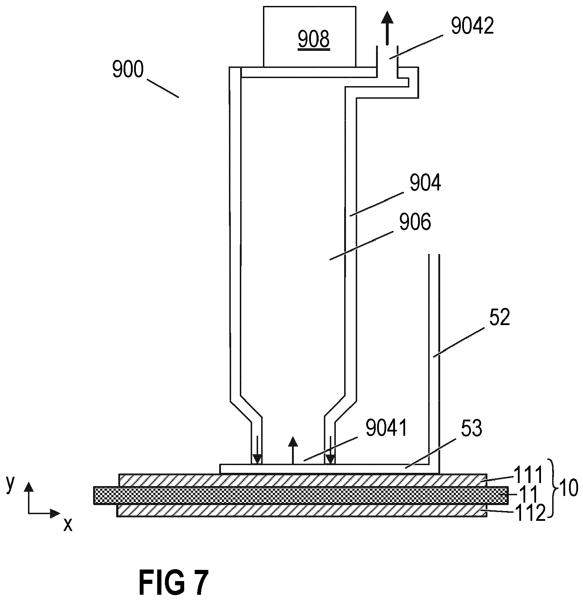

Das Anordnen der Endabschnitte 53 auf den entsprechenden Anschlussflächen 60 sowie das Verbinden der Endabschnitte 53 mit den Anschlussflächen 60 erfolgt mittels einer beispielhaft in Figur 7 dargestellten Anordnung 900. Figur 7 zeigt dabei einen Querschnitt durch eine Anordnung 900 gemäß einem Beispiel. Die Anordnung 900 weist ein Gehäuse 904 und wenigstens eine in dem Gehäuse 904 angeordnete Vakuumkammer 906 auf. Das Gehäuse 904 kann beispielsweise aus einem elektrisch nicht leitenden Material bestehen. Die Vakuumkammer 906 weist an einem ersten Ende wenigstens eine erste Öffnung 9041 zum Ansaugen eines Endabschnitts 53 eines Anschlussfußes 52 einer flexiblen leitenden Platte 51 auf. An einem zweiten, dem ersten Ende gegenüberliegenden Ende weist die Vakuumkammer 906 wenigstens eine zweite Öffnung 9042 zum Erzeugen eines Vakuums in der Vakuumkammer 906 auf. Durch die zweite Öffnung 9042 kann Luft aus der Vakuumkammer 906 gesaugt werden. Wird die erste Öffnung 9041 auf einen Endabschnitt 53 aufgesetzt, so wird dieser durch das Absaugen der Luft durch die zweite Öffnung 9042 an die erste Öffnung 9041 angesaugt und verschließt die erste Öffnung 9041 dadurch. Im Inneren der Vakuumkammer 906 kann so ein Vakuum entstehen.

Während der Endabschnitt 53 an die erste Öffnung 9041 angesaugt wird, kann der Endabschnitt 53 gleichzeitig an das Halbleitersubstrat 10 angedrückt werden. Insbesondere kann der Endabschnitt 53 an eine der auf dem Halbleitersubstrat 10 angeordneten Anschlussflächen 60 angedrückt werden. Ein Druck auf den Endabschnitt 53 in Richtung des Halbleitersubstrats 10 kann beispielsweise durch das Gehäuse 904 der Anordnung 900 erzeugt werden, indem das Gehäuse 904 auf den Endabschnitt 53 drückt. Der Endabschnitt 53 kann dadurch mittels der Anordnung 900 auf dem Substrat 10 positioniert werden. Die Position der Anschlussflächen 60 auf dem Halbleitersubstrat 10 kann beispielsweise mittels geeigneter Positionserkennungs- oder Mustererkennungsverfahren erkannt werden.

Die Anordnung 900 weist weiterhin eine Verbindungseinheit 908 auf, die dazu ausgebildet ist den Endabschnitt 53 mit dem Halbleitersubstrat 10 zu verbinden. Insbesondere kann die Verbindungseinheit 908 dazu ausgebildet sein, in einem Bereich in welchem der Endabschnitt 53 an die erste Öffnung 9041 angesaugt wird eine mechanische Verbindung zwischen dem Endabschnitt 53 und dem Halbleitersubstrat 10 herzustellen während der Endabschnitt 53 an die erste Öffnung 9041 angesaugt wird. Das Verbinden des Endabschnitts 53 mit dem Halbleitersubstrat 10 kann beispielsweise durch Erhitzen des Endabschnitts 53 erfolgen. Dadurch wird Material des Endabschnitts 53 geschmolzen und kann sich mit einem Material des darunter befindlichen Substrats 10 stoffschlüssig verbinden. Es wird dabei ein und dieselbe Anordnung 900 verwendet um den Endabschnitt 53 einerseits auf dem Halbleitersubstrat 10 zu positionieren und andererseits eine Verbindung zwischen dem Endabschnitt 53 und dem Halbleitersubstrat 10 herzustellen. Die Positionierung und Anbindung der flexiblen leitenden Platte 50 an das Halbleitersubstrat 10 kann dadurch vollständig automatisiert erfolgen. Dabei ist der Platzbedarf für die entsprechende Anordnung 900 gering im Vergleich zu Lösungen bei welchen das Positionieren und das Anbinden mittels verschiedener Anordnungen erfolgen.

Die Anordnung 900 kann beispielsweise jeden der Vielzahl von Endbereichen 53 nacheinander greifen, diesen an das Substrat 10 andrücken und mit dem Halbleitersubstrat 10 verbinden. Grundsätzlich ist es auch möglich mit mehreren Anordnungen 900 mehr als einen oder sogar alle Endabschnitte 53 gleichzeitig zu positionieren und zu verbinden. Dies erhöht jedoch den Platzbedarf durch die Vielzahl von benötigten Anordnungen 900.

Die Verbindungseinheit 908 kann grundsätzlich zumindest teilweise in dem Gehäuse 904 angeordnet oder, wie in Figur 7 dargestellt, mit dem Gehäuse 904 verbunden sein. Die Anordnung der Verbindungseinheit 908 in Bezug auf das Gehäuse 904 kann dabei von dem zur Verbindung der Endabschnitte 53 mit dem Halbleitersubstrat 10 verwendeten Verfahren abhängen. Beispielsweise kann eine Verbindung zwischen einem Endabschnitt 53 mit dem Halbleitersubstrat 10 mittels Spaltschweißen, mittels Laserschweißen oder mittels Ultraschallschweißen hergestellt werden. Andere geeignete Verfahren sind dabei ebenfalls möglich.

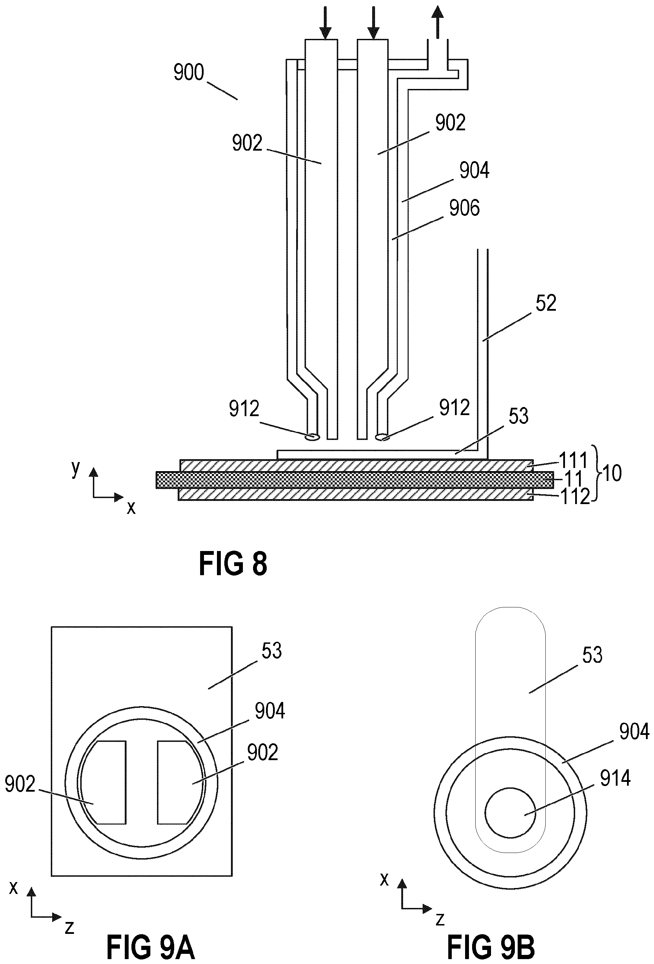

Ein Beispiel einer Anordnung 900 zum Spaltschweißen ist beispielhaft in der Querschnittsansicht in Figur 8 dargestellt. In dem in Figur 8 dargestellten Beispiel weist die Verbindungseinheit beispielsweise zwei Elektroden 902 auf. Die Elektroden 902 sind zumindest teilweise innerhalb des Gehäuses 904 und der Vakuumkammer 906 angeordnet. Dabei können entweder die Enden der Elektroden 902 oder auch lediglich benötigte Anschlüsse um die Elektroden 902 elektrisch zu kontaktieren aus dem Gehäuse 904 herausgeführt sein. Weitere benötigte Komponenten der Verbindungseinheit (in Figur 8 nicht explizit dargestellt) können beispielsweise außerhalb des Gehäuses 904 angeordnet sein. Es ist jedoch ebenfalls denkbar, alle Komponenten der Verbindungseinheit 908 vollständig innerhalb des Gehäuses 904 anzuordnen. Ein unteres Ende der Elektroden 902 ragt durch die erste Öffnung 9041 aus der Vakuumkammer 906 heraus. Dadurch kann beim Ansaugen und Anpressen des Endabschnitts 53 ein Kontakt zwischen den Elektroden 902 und dem Endabschnitt hergestellt werden. Ein Strom kann dann beispielsweise durch eine erste der beiden Elektroden 902 und den Endabschnitt 53 zu der zweiten Elektrode 902 fließen. Dadurch erwärmt sich der Endabschnitt 53 und auch der darunter befindliche Teil des Halbleitersubstrats 10. Die Bereiche werden teilweise aufgeschmolzen und so stoffschlüssig miteinander verbunden.

Wie in Figur 8 dargestellt, kann um die erste Öffnung 9041 herum eine Dichtung 912 angeordnet sein. Dadurch kann die Vakuumkammer 906 zu dem Endabschnitt 53 hin besser abgedichtet werden. Eine solche Dichtung 912 ist jedoch optional und kann auch weggelassen werden. Eine Dichtung 912 kann beispielsweise aus einem flexiblen Material wie beispielsweise Kunststoff bestehen.

Nun Bezug nehmend auf Figur 9A, ist ein horizontaler Querschnitt durch die in Figur 8 dargestellte Anordnung 900 zum Spaltschweißen beispielhaft dargestellt. In dem Querschnitt sind die in dem Gehäuse 904 angeordneten Elektroden 902 dargestellt. Unterhalb der Anordnung 900 ist auch ein Endabschnitt 53 dargestellt, welcher mit der Anordnung 900 gegriffen und mit dem Halbleitersubstrat 10 verbunden wird.

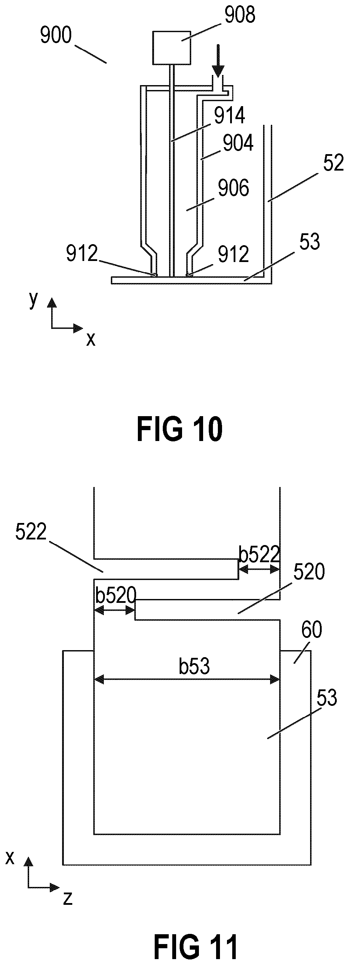

In dem horizontalen Querschnitt in Figur 9B sowie der vertikalen Querschnittsansicht in Figur 10 ist beispielhaft eine Anordnung 900 zum Laserschweißen dargestellt. In diesem Beispiel kann die Verbindungseinheit 908 komplett außerhalb des Gehäuses 904 angeordnet sein. Die Verbindungseinheit 908 ist in diesem Beispiel dazu ausgebildet, einen Laserstrahl 914 zu erzeugen. Das Gehäuse 904 kann beispielsweise zumindest teilweise durchsichtig sein. Beispielsweise kann das Gehäuse 904 an seiner Oberseite zumindest teilweise aus Glas bestehen. Dies ermöglicht es einen Laserstrahl 914 außerhalb des Gehäuses 904 zu erzeugen und durch das Gehäuse 904, insbesondere die Vakuumkammer 906, hindurch auf den Endabschnitt 53 zu richten. Der Laserstrahl 914 kann in dem Bereich der durch die erste Öffnung 9041 begrenzt wird auf den Endabschnitt 53 auftreffen. Dadurch kann der Endabschnitt 53 und der darunter befindliche Bereich des Halbleitersubstrats 10 wiederum erhitzt werden um eine Verbindung herzustellen.

Bei einer Anordnung 900 zum Ultraschallschweißen (nicht explizit dargestellt), kann beispielsweise eine Sonotrode wenigstens teilweise in dem Gehäuse 904 und der Vakuumkammer 906 angeordnet sein und durch die erste Öffnung 9041 herausragen, so dass die Sonotrode während des Anpressens des Endabschnitts 53 an das Halbleitersubstrat 10 Kontakt zu dem Endabschnitt 53 hat. Die Sonotrode kann dann mittels hochfrequenter mechanischer Schwingungen angeregt werden. Dadurch wird wiederum der Endabschnitt 53 und der darunter befindliche Bereich des Halbleitersubstrats 10 erhitzt und eine Verbindung hergestellt.

Während des Herstellens der Verbindung zwischen Endabschnitt 53 und Halbleitersubstrat 10 können, unabhängig von dem verwendeten Verfahren, Dämpfe entstehen oder es können sich Partikel von dem Endabschnitt 53 oder dem Halbleitersubstrat 10 lösen. Diese können bei Verwendung der beschriebenen Anordnung 900 leicht abgeführt werden, so dass diese sich nicht anlagern und negativ auf die Funktion des Halbleitermoduls auswirken können. Beispielsweise kann die Anordnung 900 hierfür eine geeignete Absaugeinheit aufweisen. Eine solche Absaugeinheit kann beispielsweise an oder in dem Gehäuse 904 angeordnet sein.

Nun Bezug nehmend auf Figur 11, kann der Endbereich 53 Einschnürungen 520, 522 aufweisen um eventuelle Toleranzen bei der Herstellung der flexiblen Leiterplatte 50 und dem Ausbilden der Anschlussflächen 60 auf dem Halbleitersubstrat 10 auszugleichen. Es kann beispielsweise vorkommen, dass der Abstand zwischen zwei direkt benachbarten Endbereichen 53 nicht genau mit dem Abstand der entsprechenden Anschlussflächen 60 auf dem Halbleitersubstrat 10 übereinstimmt. In einem solchen Fall würden die Anschlussfüße 52 beim Positionieren der Endbereiche 53 auf den entsprechenden Anschlussflächen 60 möglicherweise geringfügig verbogen werden. Dies kann zu Spannungen in den Anschlussfüßen 52 und letztendlich zu Beschädigungen der Anschlussfüße 52 führen. Um dies zu vermeiden bilden die in Figur 11 beispielhaft dargestellten Einschnürungen 520, 522 eine flexible Stelle in den Anschlussfüßen 52, welche geringfügige Verbiegungen erlaubt, ohne dass sich große Spannungen in den Anschlussfüßen 52 ausbilden. Im Bereich der Einschnürungen 520, 522 ist eine Breite des entsprechenden Endbereichs 53 lokal verringert. Der Endbereich 53 kann beispielsweise eine Breite b53 in einer zweiten horizontalen Richtung z aufweisen. Eine Breite b520, b522 des Endbereichs 53 im Bereich der Einschnürungen 520, 522 kann beispielsweise weniger als 50%, weniger als 30% oder weniger als 25% der Breite b53 des Endabschnitts 53 betragen. Eine gewisse Breite b520, b522 kann dabei jedoch mindestens erforderlich sein, um ein Abreißen des Endbereiches 53 zu vermeiden. Die Breite b520, b522 im Bereich der Einschnürungen 520, 522 kann beispielsweise mindestens 10% oder mindestens 20% der Breite b53 des Endbereichs 53 betragen.

Jeder Endbereich 53 kann beispielsweise zwei Einschnürungen 520, 522 aufweisen, welche sich von entgegengesetzten Seiten in der zweiten horizontalen Richtung z in den Endbereich 53 hinein erstrecken. Der Endbereich 53 kann daher im Bereich der Einschnürungen 520 beispielsweise eine S-Form oder die Form einer 5 aufweisen. In manchen Fällen können auch mehr als zwei Einschnürungen 520, 522 vorgesehen werden.

Die Einschnürungen 520, 522 können beispielsweise hergestellt werden, indem mittels Stanzen, mittels einem Laser, oder mittels anderer geeigneter Verfahren ein oder mehrere einfache Schnitte in dem Anschlussbein 52 vorgenommen werden. Ein solcher Schnitt kann beispielsweise Abrundungen (nicht explizit dargestellt) aufweisen. Mittels beispielsweise Stanzen, eines Lasers oder anderer geeigneter Verfahren können jedoch beispielsweise auch breitere Bereiche des Anschlussbeins 52 herausgeschnitten werden.

Ein Verfahren zum Herstellen eines Halbleitermoduls weist das Verbinden einer flexiblen leitenden Platte 50 mit einem Halbleitersubstrat 10 auf, wobei das Halbleitersubstrat 10 eine dielektrische Isolationsschicht 11, eine erste elektrisch leitende Schicht 111, eine Vielzahl von auf der ersten elektrisch leitenden Schicht angeordnete Halbleiterbauelemente 20 und eine Vielzahl von auf der ersten elektrisch leitenden Schicht 111 angeordnete Anschlussflächen 60 aufweist, und wobei die flexible leitende Platte 50 einen Grundkörper 51 und eine Vielzahl von Anschlussfüßen 52 aufweist, wobei sich der Grundkörper 51 in einer ersten horizontalen oder einer vertikalen Ebene erstreckt und die Anschlussfüße 52 mit einem ersten Ende mit dem Grundkörper 51 verbunden sind und sich in einer vertikalen Richtung y senkrecht zu der ersten horizontalen Ebene von dem Grundkörper 50 weg erstrecken, und wobei jeder der Anschlussfüße 52 an einem zweiten, dem ersten gegenüberliegenden Ende einen Endabschnitt 53 aufweist, welcher sich in einer zweiten horizontalen Ebene parallel zu der ersten horizontalen Ebene erstreckt. Das Verbinden der flexiblen leitenden Platte 50 mit dem Halbleitersubstrat 10 weist das Verbinden jedes der Endabschnitte 53 mit einer der Vielzahl von Anschlussflächen 60 auf. Das Verbinden jedes der Endabschnitte 53 mit einer der Vielzahl von Anschlussflächen 60 weist das Ansaugen jedes der Endabschnitte 53, das Andrücken des entsprechenden Endabschnitts 53 an eine entsprechende Anschlussfläche 60, und das mechanische Verbinden des Endabschnitts 53 mit der Anschlussfläche 60 mittels einer oben beschriebenen Anordnung auf.

Das Verfahren kann weiterhin das Herstellen der flexiblen leitenden Platte 50 derart aufweisen, dass sich der Grundkörper 51, die Vielzahl von Anschlussfüßen 52 und die Endbereiche 53 in einer Ausgangslage in einer zweiten horizontalen Ebene erstrecken.

Das Herstellen der flexiblen leitenden Platte 50 kann das Stanzen einer flachen Folie oder das Zuschneiden einer flachen Folie aufweisen.

Das Herstellen der flexiblen leitenden Platte 50 kann weiterhin das Umbiegen des Grundkörpers 51 und der Vielzahl von Anschlussfüßen 52 aus ihrer Ausgangslage heraus aufweisen, so dass sich der Grundkörper 51 und die Anschlussfüße 52 nach dem Umbiegen in der vertikalen Richtung y senkrecht zu der zweiten horizontalen Ebene von dem Grundkörper 50 weg erstrecken.

Das Herstellen der flexiblen leitenden Platte 50 kann weiterhin das erneute Umbiegen des Grundkörpers 51 aufweisen, so dass sich der Grundkörper 51 nach dem erneuten Umbiegen senkrecht zu den Anschlussfüßen 52 in einer ersten horizontalen Ebene parallel zu der zweiten horizontalen Ebene erstreckt.

Das Ansaugen jedes der Endabschnitte 53 mittels des Werkzeugs 900 kann das Erzeugen eines Vakuums in der wenigstens einen Vakuumkammer 906 aufweisen.

Jeder der Vielzahl von Endabschnitte 53 kann unter Verwendung eines Spaltschweißverfahrens, eines Laserschweißverfahrens oder eines Ultraschallschweißverfahrens mit der entsprechenden Anschlussfläche 60 verbunden werden.

Die Vielzahl von Endabschnitten 53 kann jeweils nacheinander mit einem unterschiedlichen der Anschlussbereiche 60 verbunden werden.

## Patentansprüche

1. Anordnung (900) mit
einem Gehäuse (904);
wenigstens einer in dem Gehäuse (904) angeordneten Vakuumkammer (906), wobei die Vakuumkammer (906) wenigstens eine erste Öffnung (9041) zum Ansaugen eines Endabschnitts (53) eines Anschlussfußes (52) einer flexiblen leitenden Platte (50) an einem ersten Ende, und eine zweite Öffnung (9042) zum Erzeugen eines Vakuums in der Vakuumkammer (906) an einem zweiten, dem ersten Ende gegenüberliegenden Ende aufweist; und
einer Verbindungseinheit (908), die dazu ausgebildet ist in einem Bereich in welchem der Endabschnitt (53) an die erste Öffnung (9041) angesaugt wird eine mechanische Verbindung zwischen dem Endabschnitt (53) und einem Halbleitersubstrat (10) herzustellen während der Endabschnitt (53) an die erste Öffnung (9041) angesaugt wird, wobei das Halbleitersubstrat (10) eine dielektrische Isolationsschicht (11), eine erste elektrisch leitende Schicht (111), eine Vielzahl von auf der ersten elektrisch leitenden Schicht angeordneten Halbleiterbauelementen (20) und eine Vielzahl von auf der ersten elektrisch leitenden Schicht (111) angeordneten Anschlussflächen (60) aufweist.

2. Anordnung (900) nach Anspruch 1, wobei die Verbindungseinheit (908) zumindest teilweise in dem Gehäuse (906) angeordnet oder mit dem Gehäuse (906) verbunden ist.

3. Anordnung (900) nach Anspruch 1 oder 2, wobei die Verbindungseinheit (908) dazu ausgebildet ist, den Endabschnitt (53) unter Verwendung eines Laserschweißverfahrens mit dem Halbleitersubstrat (10) zu verbinden.

4. Anordnung (900) nach Anspruch 3, wobei die Verbindungseinheit (908) dazu ausgebildet ist, während ein Endabschnitt (53) an die erste Öffnung (9041) angesaugt wird, einen Laserstrahl (914) zu erzeugen, welcher durch die Vakuumkammer (906) und die erste Öffnung (9041) hindurch auf den Endabschnitt (53) gerichtet ist.

5. Anordnung (900) nach Anspruch 1 oder 2, wobei die Verbindungseinheit (908) dazu ausgebildet ist, den Endabschnitt (53) unter Verwendung eines Spaltschweißverfahrens mit dem Halbleitersubstrat (10) zu verbinden.

6. Anordnung (900) nach Anspruch 5, wobei die Verbindungseinheit (908) eine erste und eine zweite Elektrode (902) aufweist, wobei die erste und die zweite Elektrode (902) wenigstens teilweise innerhalb des Gehäuses (904) und der Vakuumkammer (906) angeordnet sind.

7. Anordnung (900) nach Anspruch 1 oder 2, wobei die Verbindungseinrichtung (908) dazu ausgebildet ist, den Endabschnitt (53) unter Verwendung eines Ultraschallschweißverfahrens mit dem Halbleitersubstrat (10) zu verbinden.

8. Verfahren zum Herstellen eines Halbleitermoduls (100), wobei das Verfahren aufweist:
Verbinden einer flexiblen leitenden Platte (50) mit wenigstens einem Halbleitersubstrat (10), wobei jedes des wenigstens einen Halbleitersubstrats (10) eine dielektrische Isolationsschicht (11), eine erste elektrisch leitende Schicht (111), eine Vielzahl von auf der ersten elektrisch leitenden Schicht angeordnete Halbleiterbauelemente (20) und eine Vielzahl von auf der ersten elektrisch leitenden Schicht (111) angeordnete Anschlussflächen (60) aufweist, und wobei die flexible Leiterplatte (50) einen Grundkörper (51) und eine Vielzahl von Anschlussfüßen (52) aufweist, wobei sich der Grundkörper (51) in einer ersten horizontalen oder einer vertikalen Ebene erstreckt und die Anschlussfüße (52) mit einem ersten Ende mit dem Grundkörper (51) verbunden sind und sich in einer vertikalen Richtung (y) senkrecht zu der ersten horizontalen Ebene von dem Grundkörper (50) weg erstrecken, und wobei jeder der Anschlussfüße (52) an einem zweiten, dem ersten gegenüberliegenden Ende einen Endabschnitt (53) aufweist, welcher sich in einer zweiten horizontalen Ebene parallel zu der ersten horizontalen Ebene erstreckt, wobei
das Verbinden der flexiblen leitenden Platte (50) mit dem wenigstens einen Halbleitersubstrat (10) das Verbinden jedes der Endabschnitte (53) mit einer der Vielzahl von Anschlussflächen (60) aufweist, und
das Verbinden jedes der Endabschnitte (53) mit einer der Vielzahl von Anschlussflächen (60) das Ansaugen jedes der Endabschnitte (53), das Andrücken des entsprechenden Endabschnitts (53) an eine entsprechende Anschlussfläche (60), und das mechanische Verbinden des Endabschnitts (53) mit der Anschlussfläche (60) mittels einer Anordnung gemäß einem der Ansprüche 1 - 8 aufweist.

9. Verfahren nach Anspruch 8 das weiterhin aufweist:
Herstellen der flexiblen leitenden Platte (50) derart, dass sich der Grundkörper (51), die Vielzahl von Anschlussfüßen (52) und die Endbereiche (53) in einer Ausgangslage in der zweiten horizontalen Ebene erstrecken.

10. Verfahren nach Anspruch 9, wobei das Herstellen der flexiblen leitenden Platte (50) aufweist:
Stanzen einer flachen Folie; oder
Zuschneiden einer flachen Folie.

11. Verfahren nach Anspruch 10, wobei das Herstellen der flexiblen leitenden Platte (50) weiterhin aufweist:
Umbiegen des Grundkörpers (51) und der Vielzahl von Anschlussfüßen (52) aus ihrer Ausgangslage heraus, so dass sich der Grundkörper (51) und die Anschlussfüße (52) nach dem Umbiegen in der vertikalen Richtung (y) senkrecht zu der zweiten horizontalen Ebene von den Endabschnitten (53) weg erstrecken.

12. Verfahren nach Anspruch 11, wobei das Herstellen der flexiblen leitenden Platte (50) weiterhin aufweist:
erneutes Umbiegen des Grundkörpers (51), so dass sich der Grundkörper (51) nach dem erneuten Umbiegen senkrecht zu den Anschlussfüßen (52) in einer ersten horizontalen Ebene parallel zu der zweiten horizontalen Ebene erstreckt.

13. Verfahren nach einem der Ansprüche 9 bis 12, wobei das Ansaugen jedes der Endabschnitte (53) mittels des Werkzeugs (900) das Erzeugen eines Vakuums in der wenigstens einen Vakuumkammer (906) aufweist.

14. Verfahren nach einem der Ansprüche 9 bis 13, wobei jeder der Vielzahl von Endabschnitte (53) unter Verwendung eines Spaltschweißverfahrens, eines Laserschweißverfahrens oder eines Ultraschallschweißverfahrens mit der entsprechenden Anschlussfläche (60) verbunden wird.

15. Verfahren nach einem der Ansprüche 9 bis 14, wobei die Vielzahl von Endabschnitten (53) jeweils nacheinander mit einem unterschiedlichen der Anschlussbereiche (60) des wenigstens einen Halbleitersubstrates (10) verbunden werden.
